(19) **Europäisches Patentamt / European Patent Office / Office européen des brevets**

(11) **EP 4 496 157 A1**

(12) **EUROPEAN PATENT APPLICATION**
published in accordance with Art. 153(4) EPC

(43) Date of publication:
**22.01.2025  Bulletin 2025/04**

(21) Application number: **23770630.4**

(22) Date of filing: **09.03.2023**

(51) International Patent Classification (IPC):
*H01S 5/343* (2006.01)      *C23C 16/18* (2006.01)
*C23C 16/34* (2006.01)      *C30B 25/02* (2006.01)
*C30B 29/38* (2006.01)      *H01L 21/205* (2006.01)
*H01L 33/10* (2010.01)      *H01L 33/32* (2010.01)
*H01S 5/183* (2006.01)

(52) Cooperative Patent Classification (CPC):
**C23C 16/18; C23C 16/34; C30B 25/02;**
**C30B 29/38; H01L 21/2015; H01L 33/10;**
**H01L 33/32; H01S 5/183; H01S 5/343**

(86) International application number:
**PCT/JP2023/009011**

(87) International publication number:
**WO 2023/176674 (21.09.2023 Gazette 2023/38)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **16.03.2022  JP 2022040955**

(71) Applicants:
• **Meijo University**
  **Nagoya-shi, Aichi 468-8502 (JP)**
• **Stanley Electric Co., Ltd.**
  **Meguro-ku**
  **Tokyo 153-8636 (JP)**

(72) Inventors:
• **TAKEUCHI, Tetsuya**
  **Nagoya-shi, Aichi 468-8502 (JP)**
• **SHIBATA, Kana**
  **Nagoya-shi, Aichi 468-8502 (JP)**
• **IWAYA, Motoaki**
  **Nagoya-shi, Aichi 468-8502 (JP)**
• **KAMIYAMA, Satoshi**
  **Nagoya-shi, Aichi 468-8502 (JP)**
• **KURAMOTO, Masaru**
  **Tokyo 153-8636 (JP)**

(74) Representative: **Müller-Boré & Partner**
**Patentanwälte PartG mbB**
**Friedenheimer Brücke 21**
**80639 München (DE)**

(54) **METHOD FOR MANUFACTURING NITRIDE SEMICONDUCTOR LIGHT-EMITTING ELEMENT, AND NITRIDE SEMICONDUCTOR LIGHT-EMITTING ELEMENT**

(57)    Provided are a method for manufacturing a nitride semiconductor light-emitting element having good quality, and a nitride semiconductor light-emitting element having good quality. A method for manufacturing a nitride semiconductor light-emitting element by metal organic vapor phase epitaxy, the method including: a first layer stacking step of crystal-growing an n-AlInN layer (12) containing Al and In in a composition; a cap layer stacking step of crystal-growing a GaN cap layer (13) containing Ga in a composition on a surface of the n-AlInN layer (12) after performing the first layer stacking step; and a second layer stacking step of crystal-growing a GaN layer (14) containing Ga in a composition on a surface of the GaN cap layer (13) after performing the cap layer stacking step. The method for manufacturing a nitride semiconductor light-emitting element further includes a hydrogen cleaning step of stopping supply of a raw material gas into a reaction furnace and supplying hydrogen into the reaction furnace to clean at least a surface of the GaN cap layer (13), after performing the cap layer stacking step and before performing the second layer stacking step.

EP 4 496 157 A1

# Fig. 2

**Description**

TECHNICAL FIELD

The present invention relates to a method for manufacturing a nitride semiconductor light-emitting element, and a nitride semiconductor light-emitting element.

BACKGROUND ART

In the case of manufacturing a semiconductor multilayer film by stacking nitride semiconductor thin films having different band gaps and refractive indexes, it has been a problem, particularly in a multilayer reflector formed of nitride semiconductor thin films containing In, that defects such as threading dislocations exist at high density. Patent Literature 1 discloses a method (hydrogen treatment) of performing a step of introducing hydrogen immediately after formation of the AlInN layer, thereby removing clusters of In existing on the surface of an AlInN layer and suppressing occurrence of defects such as threading dislocations. Patent Literature 2 discloses that occurrence of defects such as threading dislocations is suppressed by making a decrease rate of an In composition larger than a decrease rate of an Al composition at the interface between an upper part of an AlInN layer and a lower part of a GaN layer, that is, a structure in which a layer having substantially less In exists at the interface between the AlInN layer and the GaN layer. Specifically, Patent Literature 2 discloses that a cap layer having a thickness of more than 0 nm and 1 nm or less and containing no In is formed immediately after formation of the AlInN layer, and then a temperature increasing step of increasing the substrate temperature is performed, thereby removing clusters of In existing on the surface of the AlInN layer and suppressing occurrence of defects (temperature increasing treatment). Here, the cap layer includes not only a state of uniformly covering the surface of the AlInN layer, but also a state of being formed in an island shape on the surface of the AlInN layer.

CITATIONS LIST

PATENT LITERATURE

Patent Literature 1: JP 2018-14444 A
Patent Literature 2: JP 2018-98347 A

SUMMARY OF INVENTION

TECHNICAL PROBLEMS

Under such circumstances, as a result of studying several nitride semiconductor thin-film multilayer structures for the purpose of forming an element structure, the following new problems have been found. Specifically, the problem is the case of forming a structure having a layer containing In on the surface of the AlInN layer. First, since the temperature is increased in the above-described temperature increasing step, it is difficult to form a structure having a layer containing In. On the other hand, it has been newly found that, in the hydrogen treatment described above, pits (holes) are generated on the surface of the AlInN layer at a density significantly higher than the dislocation density of the substrate, resulting in significant deterioration of the surface flatness. It is considered that the pits appear on the surface of the crystal due to the presence of crystal defects such as threading dislocations. As described above, it has been clear that there is a case where suppression of occurrence of dislocations is insufficient only by the techniques disclosed in Patent Literatures 1 and 2 (that is, a case where a structure having a layer containing In, in which crystal growth with a low growth temperature is essential, is crystal-grown on the surface of the AlInN layer).

The present invention has been made in view of the above conventional circumstances, and an object of the present invention is to provide: a method for manufacturing a nitride semiconductor light-emitting element, in which a nitride semiconductor light-emitting element with high output and long life is manufactured by growing crystals having a low pit density, that is, few defects on a surface of the AlInN layer; and the nitride semiconductor light-emitting element.

SOLUTIONS TO PROBLEMS

A method for manufacturing a nitride semiconductor light-emitting element according to a first aspect of the present invention is a method for manufacturing a nitride semiconductor light-emitting element by metal organic vapor phase epitaxy, the method including:

a first layer stacking step of crystal-growing a first layer containing Al and In in a composition;
a cap layer stacking step of crystal-growing a cap layer containing Ga in a composition on a surface of the first layer after performing the first layer stacking step; and
a second layer stacking step of crystal-growing a second layer containing at least one of Ga and In in a composition on a surface of the cap layer after performing the cap layer stacking step, wherein
the method further includes a hydrogen cleaning step of stopping supply of a raw material gas into a reaction furnace and supplying hydrogen into the reaction furnace to clean at least a surface of the cap layer, after performing the cap layer stacking step and before performing the second layer stacking step.

According to this configuration, by cleaning the surface of the crystal after performing the cap layer stacking step, with hydrogen, the second layer to be stacked next can be favorably crystal-grown.

A nitride semiconductor light-emitting element according to a second aspect of the present invention includes:

a first layer containing Al and In in a composition;
a cap layer stacked on a surface of the first layer and containing Ga in a composition; and
a second layer stacked on a surface of the cap layer and containing at least one of Ga and In in a composition, wherein
a band gap of the cap layer is smaller than a band gap of a region adjacent to the cap layer in the first layer and the second layer.

According to this configuration, due to the cap layer, the second layer to be stacked next can be favorably crystal-grown. Further, Ga contained in the cap layer is diffused to some extent into the first layer and the second layer vertically adjacent to the cap layer, which reduces the band offset in the cap layer, so that electrons in the cap layer can be smoothly moved.

BRIEF DESCRIPTION OF DRAWINGS

[Fig. 1] Fig. 1 is a schematic view illustrating an example of a structure of a nitride semiconductor light-emitting element 1 manufactured by a method for manufacturing a nitride semiconductor light-emitting element.
[Fig. 2] Fig. 2 is a time chart showing a first layer stacking step, a cap layer stacking step, a hydrogen cleaning step, a second layer stacking step, and a step of stacking a GaInN quantum well active layer in the method for manufacturing a nitride semiconductor light-emitting element.
[Fig. 3] (A) to (H) are images obtained by observing, with an atomic force microscope, the surface of the GaInN quantum well active layer of each sample in which the thickness of the GaN cap layer is changed by changing the time of performing the cap layer stacking step. (I) is an image obtained by observing, with an atomic force microscope, the surface of the GaInN quantum well active layer of a sample prepared without performing the cap layer stacking step and the hydrogen cleaning step.
[Fig. 4] Fig. 4 is a graph plotting the relationship between the thickness of the GaN cap layer and the pit density in each sample in which the thickness of the GaN cap layer is changed by changing the time of performing the cap layer stacking step.
[Fig. 5] Fig. 5 is a schematic view illustrating a structure of a nitride semiconductor light-emitting element 2 manufactured by a method for manufacturing a nitride semiconductor light-emitting element.
[Fig. 6] Fig. 6 is a table showing the flow rates of $H_2$ and $NH_3$ into the reaction furnace, the supply time of $H_2$ into the reaction furnace, the numerical value A, and the pit density in each sample in which the supply rates of $H_2$ and $NH_3$ into the reaction furnace are changed and the supply time of $H_2$ into the reaction furnace is changed in the hydrogen cleaning step.
[Fig. 7] Fig. 7 is a graph plotting the relationship between the numerical value A and the pit density in each sample in which the supply rates of $H_2$ and $NH_3$ into the reaction furnace are changed and the supply time of $H_2$ into the reaction furnace is changed in the hydrogen cleaning step.
[Fig. 8] Fig. 8 is a schematic view illustrating a structure of a sample of Comparative Example 4.
[Fig. 9] Fig. 9 is a graph showing a profile of Ga, Al, and In concentrations in the depth direction, which is obtained by SIMS analysis in a sample of Comparative Example 4.
[Fig. 10] Fig. 10 is a schematic view showing energy levels of the bottom of the valence band in samples of Examples 7 to 10 and Comparative Example 7.
[Fig. 11] Fig. 11 is a graph showing current-voltage characteristics of samples of Comparative Example 7 and Example 9.

DESCRIPTION OF EMBODIMENTS

Preferred embodiments of the present invention will be described.
In the first aspect of the present invention, the thickness of the cap layer in the stacking direction may be 0.3 nm or more and 5 nm or less. According to this configuration, it is possible to favorably suppress dislocations occurred in the second layer when the second layer is stacked in the second layer stacking step.
In the first aspect of the present invention, the numerical value A in Equation 1, determined from the flow rate F1 [slm] of hydrogen supplied into the reaction furnace in the hydrogen cleaning step, the supply time T [min] for supplying hydrogen into the reaction furnace in the hydrogen cleaning step, and the flow rate F2 [slm] of ammonia supplied into the reaction furnace in the hydrogen cleaning step, may be 20 or more and 80 or less.

$$A = (F1 \times T)/F2$$

…

According to this configuration, the effect of cleaning with hydrogen on the surface of the crystal after the cap layer stacking step can be enhanced by adjusting the flow rate F1 [slm] of hydrogen supplied into the reaction furnace in the hydrogen cleaning step, the supply time T [min] for supplying hydrogen into the reaction furnace in the hydrogen cleaning step, and the flow rate F2 [slm] of ammonia supplied into the reaction furnace in the hydrogen cleaning step, thereby setting the numerical value A within the above-described range. When the numerical value A is too small, the cleaning effect is lost, and when the numerical value A is too large, the influence of the surface damage due to hydrogen starts to occur.

In the first aspect of the present invention, the growth temperature in the second layer stacking step may be equal to or lower than the growth temperature in the first layer stacking step. According to this configuration, it is possible to suppress the influence of heat on the first layer containing In.

In the second aspect of the present invention, the thickness of the cap layer in the stacking direction may be 0.3 nm or more and 5 nm or less. According to this configuration, dislocations occurred in the second layer can be favorably suppressed when the second layer is stacked.

In the second aspect of the present invention, the surface concentration of Ga in the cap layer may be $2.5 \times 10^{14}$ cm$^{-2}$ or more and $4.1 \times 10^{15}$ cm$^{-2}$ or less. According to this configuration, dislocations occurred in the second layer can be favorably suppressed when the second layer is stacked.

<Examples 1 to 6 and Comparative Examples 1 to 4>

Next, an example of a method for manufacturing a nitride semiconductor light-emitting element of the present invention will be described with reference to the drawings. This manufacturing method is an example of a method for manufacturing a light-emitting diode (hereinafter, also referred to as nitride semiconductor light-emitting element 1) using an element structure in which a GaInN/GaN multiple quantum well active layer (light-emitting layer) is formed on a surface side of the AlInN layer with the GaN layer interposed therebetween. This element structure can be a basic structure of various optical device structures such as a laser diode and a solar cell, in addition to the light-emitting diode.

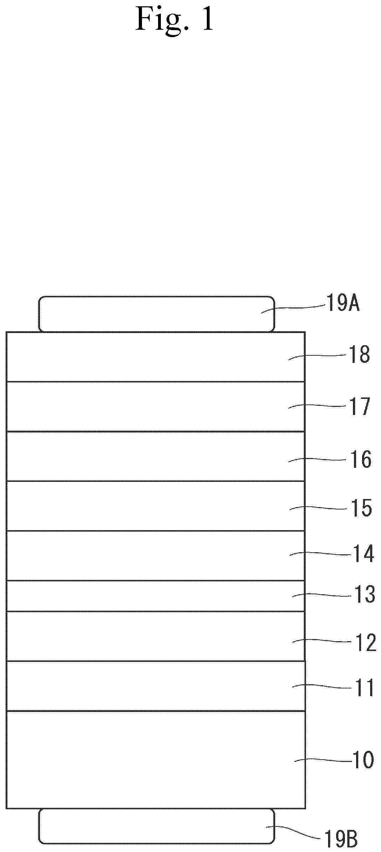

As illustrated in Fig. 1, the nitride semiconductor light-emitting element 1 includes an n-GaN substrate 10, an n-GaN buffer layer 11, an n-AlInN layer 12 as a first layer, a GaN cap layer 13 as a cap layer, a GaN layer 14 as a second layer, a GaInN quantum well active layer 15, a p-AlGaN layer 16, a p-GaN layer 17, a p-GaN contact layer 18, a p-side electrode 19A, and an n-side electrode 19B. The n-GaN substrate 10 is a single crystal substrate of GaN (gallium nitride) having n-type characteristics. The nitride semiconductor light-emitting element 1 can be manufactured by performing epitaxial growth on the surface (upper surface in Fig. 1) of the n-GaN substrate 10 by using metal organic vapor phase epitaxy (MOVPE).

In manufacturing the nitride semiconductor light-emitting element 1, trimethyl aluminum (TMA), trimethyl gallium (TMGa), triethyl gallium (TEGa), and trimethyl indium (TMI) are used as group III materials (MO raw materials). In addition, ammonia (NH$_3$) is used as a raw material gas of a group V material. SiH$_4$ (silane) is used as a raw material gas of a donor impurity. CP$_2$Mg (cyclopentadienyl magnesium) is used as an MO raw material of an acceptor impurity.

First, the n-GaN buffer layer 11 as a buffer layer is crystal-grown with a thickness of 500 nm on the surface of the n-GaN substrate 10. Specifically, the n-GaN substrate 10 is disposed in a reaction furnace of an MOVPE apparatus (hereinafter, also simply referred to as the reaction furnace). Then, the temperature in the reaction furnace is adjusted such that the temperature (growth temperature) of the n-GaN substrate 10 is 1,050°C, and hydrogen (H$_2$) is supplied as a carrier gas into the reaction furnace. The supply amount of SiH$_4$ into the reaction furnace is adjusted such that the concentration of Si (silicon) in the n-GaN buffer layer 11 becomes $5 \times 10^{18}$ cm$^{-3}$.

[First layer stacking step]

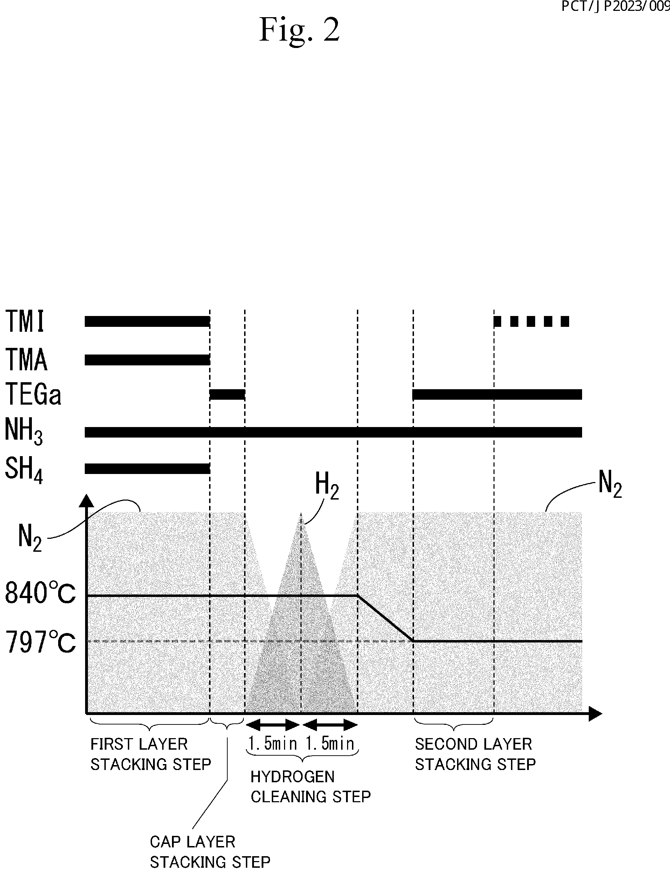

Next, a first layer stacking step is performed. Specifically, the n-AlInN layer 12 containing Al and In in the composition is epitaxially grown on the surface of the n-GaN buffer layer 11. More specifically, as shown in Fig. 2, the temperature in the reaction furnace is adjusted such that the temperature (growth temperature) of the n-GaN substrate 10 becomes 840°C, and nitrogen (N$_2$) is supplied as a carrier gas into the reaction furnace. In addition, TMA, TMI, SiH$_4$, and NH$_3$ at a flow rate of 4 L/min are supplied into the reaction furnace to crystal-grow the n-AlInN layer 12 having a thickness of 43 nm. The mole fraction of AlN in the n-AlInN layer 12 is 82%, and the mole fraction of InN is 18%. The supply amount of SiH$_4$ into the reaction furnace is adjusted such that the concentration of Si in the n-AlInN layer 12 becomes $1.5 \times 10^{19}$ cm$^{-3}$. In addition to N$_2$, the carrier gas may be an inert gas such as Ar (argon) or a mixed gas thereof.

[Cap layer stacking step]

Next, after the first layer stacking step is performed, a cap layer stacking step is performed. Specifically, as shown in Fig. 2, the supply of TMA, TMI, and SiH$_4$ is stopped and TEGa is supplied into the reaction furnace while the temperature (growth temperature) of the n-GaN substrate 10 and the supply of the carrier gas (N$_2$) and NH$_3$ into the reaction furnace are maintained, whereby the GaN cap layer 13 containing Ga in the composition is crystal-grown with a predetermined thickness on the surface of the n-AlInN layer 12. The thickness of the GaN cap layer 13 can be varied by changing the supply time of TEGa into the reaction furnace.

[Hydrogen cleaning step]

After the supply of TEGa (raw material gas) into the reaction furnace is stopped to complete the crystal growth of the GaN cap layer 13, that is, after the cap layer stacking step is performed, a hydrogen cleaning step is performed. Specifically, as shown in Fig. 2, the temperature of the n-GaN substrate 10 is maintained at the temperature in the cap layer stacking step (840°C), and the carrier gas supplied into the reaction furnace at a flow rate of 16 L/min is gradually switched from $N_2$ to $H_2$. Specifically, while the flow rate of the carrier gas supplied into the reaction furnace is maintained at 16 L/min, the ratio of $N_2$ is decreased and the ratio of $H_2$ is increased.

Here, if the supply of $H_2$ is started at the same time as the start of the hydrogen cleaning step, immediately after the supply of $N_2$ into the reaction furnace is stopped, the gas flow in the reaction furnace may be disturbed. Therefore, the carrier gas is gradually switched from $N_2$ to $H_2$ at the same time as the start of the hydrogen cleaning step to thereby prevent the flow rate of the carrier gas supplied into the reaction furnace from changing, whereby the disturbance of the gas flow in the reaction furnace is suppressed. In principle, if the flow rate of the carrier gas supplied into the reaction furnace does not vary, the supply of $H_2$ into the reaction furnace may be started at the same time as the start of the hydrogen cleaning step, immediately after the supply of $N_2$ is stopped. In the method for manufacturing the nitride semiconductor light-emitting element 1, the carrier gas is completely switched from $N_2$ to $H_2$ over 1.5 minutes (see Fig. 2). $H_2$ starts to be supplied into the reaction furnace by this operation, and the surface of the n-AlInN layer 12 including the thin GaN cap layer 13 can be cleaned with $H_2$.

A state in which only $H_2$ is supplied as a carrier gas into the reaction furnace may be maintained as it is for a desired time. However, in the method for manufacturing the nitride semiconductor light-emitting element 1, the time for maintaining a state in which only $H_2$ is supplied as a carrier gas into the reaction furnace is not provided, but immediately at the timing at which the carrier gas becomes only $H_2$, the carrier gas is gradually switched from $H_2$ to $N_2$. Specifically, while the flow rate of the carrier gas supplied into the reaction furnace is maintained at 16 L/min, the ratio of $H_2$ is decreased and the ratio of $N_2$ is increased over 1.5 minutes. In this way, since $H_2$ is gradually introduced into the reaction furnace over 3 minutes, the supply amount of $H_2$ supplied into the reaction furnace is $(16 \text{ [L/min]} \times 3 \text{ [min]}) \div 2 = 24 \text{ [L]}$, which is substantially equivalent to a case where 16 slm of $H_2$ is supplied into the reaction furnace for 1.5 minutes. Thus, in the hydrogen cleaning step, hydrogen is supplied into the reaction furnace to clean the surface of the GaN cap layer 13. Here, in a case where the GaN cap layer 13 is formed in an island shape on the surface of the n-AlInN layer 12, hydrogen is supplied into the reaction furnace in the hydrogen cleaning step, thereby cleaning the surfaces of the GaN cap layer 13 and the n-AlInN layer 12.

[Second layer stacking step]

Next, a second layer stacking step is performed.

Specifically, as shown in Fig. 2, after the cap layer stacking step and the hydrogen cleaning step are performed, the temperature of the n-GaN substrate 10 is lowered from the temperature (840°C) used at the time of crystal-growing the n-AlInN layer 12 to 797°C, and the supply of TEGa into the reaction furnace is started while a state in which the carrier gas is $N_2$ is maintained, whereby the GaN layer 14 having a thickness of 30 nm is crystal-grown on the surface of the GaN cap layer 13. The GaN layer 14 contains Ga in the composition. The growth temperature in the second layer stacking step is lower than the growth temperature in the first layer stacking step. The hydrogen cleaning step is performed before the second layer stacking step is performed.

Subsequently, the GaInN quantum well active layer 15 (MQW) is grown while the supply of $NH_3$ and TEGa into the reaction furnace is maintained. Specifically, the supply of TMIn into the reaction furnace is started and a GaInN quantum well layer having a thickness of 3 nm is crystal-grown, and then the supply of TMIn is stopped and a GaN barrier layer having a thickness of 6 nm is crystal-grown. The GaInN quantum well active layer 15 has a configuration in which five pairs each consisting of one GaInN quantum well layer and one GaN barrier layer are stacked. After the crystal growth of the last GaN barrier layer is completed, the supply of TEGa into the reaction furnace is stopped to complete the crystal growth of the GaInN quantum well active layer 15.

[Verification of effect of GaN cap layer and hydrogen cleaning step]

Here, in order to verify the effects of the GaN cap layer 13 and the hydrogen cleaning step, a total of 8 kinds of samples of Examples 1 to 5 and Comparative Examples 1 to 3 were prepared in which the thickness of the GaN cap layer 13 was changed and crystal growth was performed up to the GaInN quantum well active layer 15. Specifically, the thickness of the GaN cap layer 13 of each of these samples was set to 0 nm (Comparative Example 1), 0.15 nm (Comparative Example 2), 0.3 nm (Example 1), 0.6 nm (Example 2), 0.9 nm (Example 3), 1.2 nm (Example 4), 2.4 nm (Example 5), and 5 nm (Example 6). The thickness of the GaN cap layer 13 in each sample was adjusted by changing the time of performing the cap layer stacking step, that is, the supply time of TEGa into the reaction furnace. Further, a sample of Comparative Example 3 was also prepared which was crystal-grown up to the GaInN quantum well active layer 15 without performing the cap layer stacking step and the hydrogen cleaning step.

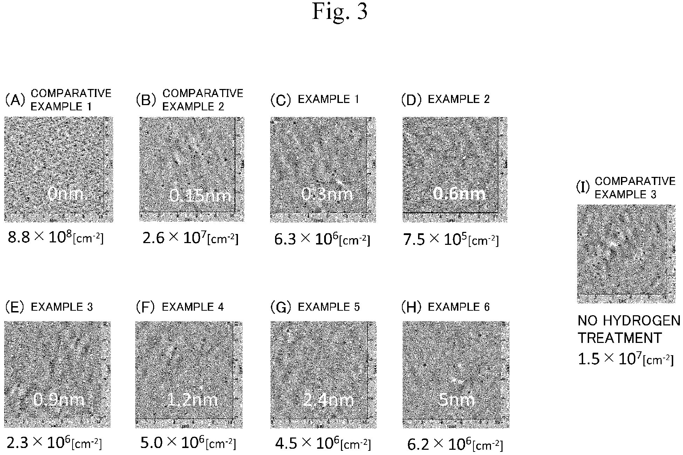

The pit density of the surface of the GaInN quantum well active layer 15 in the sample of Comparative Example 3 was $1.5 \times 10^7$ cm$^{-3}$ (see Fig. 3(I)). Here, the guaranteed value of the dislocation density of the n-GaN substrate 10 is $1 \times 10^6$ cm$^{-3}$. From this, it is considered that a bond between excessive In atoms existing on the surface of the n-AlInN layer 12 causes occurrence of dislocations at a density higher than the dislocation density of the n-GaN substrate 10.

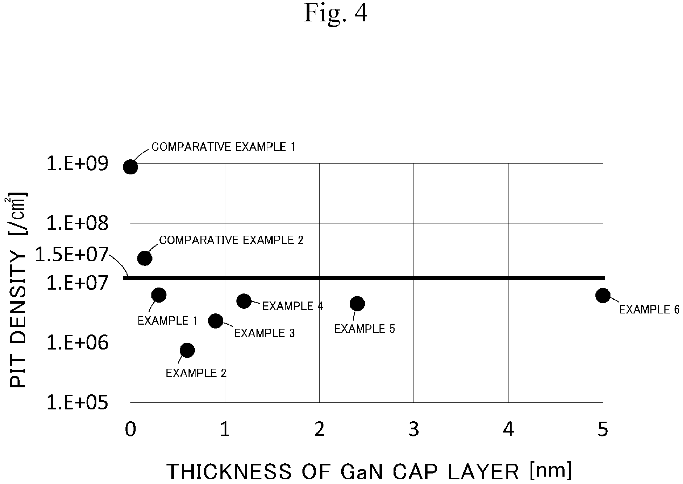

In addition, even in the sample of Comparative Example 1 in which the cap layer stacking step is not performed (GaN cap layer 13 is not present at all (0 nm)) and the hydrogen cleaning step is performed, the pit density of the surface of the GaInN quantum well active layer 15 is $8.8 \times 10^8$ cm$^{-3}$ (see Fig. 3(A) and Fig. 4). That is, it was found that the pit density of the surface of the GaInN quantum well active layer 15 is significantly higher in a case of not performing the cap layer stacking step and performing the hydrogen cleaning step than in a case of not performing both the cap layer stacking step and the hydrogen cleaning step.

In addition, it was found that the sample of Comparative Example 2 in which the thickness of the GaN cap layer 13 is 0.15 nm has a higher pit density (dislocation density) than a case without performing the hydrogen cleaning step (Comparative Example 3) (see Fig. 3(B) and Fig. 4). On the other hand, it was found that the lowest pit density is obtained in a case where the thickness of the GaN cap layer 13 is 0.6 nm (Example 2) (see Fig. 3(D) and Fig. 4). Then, it was found that the dislocation density can be effectively reduced by the hydrogen cleaning step in a case where the thickness of the GaN cap layer 13 is 1/2 (0.3 nm, Example 1) or more of the said thickness (0.6 nm) and 8.3 times (5 nm, Example 6) or less of the said thickness (0.6 nm).

Specifically, when the thickness of the GaN cap layer 13 is 0.3 nm or more and 5.0 nm or less, the pit density is $6.3 \times 10^6$ cm$^{-3}$ or less. That is, the thickness of the GaN cap layer 13 in the stacking direction is preferably 0.3 nm or more and 5 nm. It was also found that when the thickness of the GaN cap layer 13 is 0.6 nm (Example 2) or more and 1.2 nm (Example 4) or less, the pit density is $5 \times 10^6$ cm$^{-3}$ or less, which is a more preferable value. It was also found that when the thickness of the GaN cap layer 13 is 0.6 nm (Example 2) or more and 0.9 nm (Example 3) or less, the pit density is $2.3 \times 10^6$ cm$^{-3}$ or less, which is an even more preferable value. Accordingly, the thickness of the GaN cap layer 13 is more preferably 0.6 nm or more and 1.2 nm or less, and still more preferably 0.6 nm or more and 0.9 nm or less. As described above, the effect of the hydrogen cleaning step is to suppress the pit density on the surface of the stacked crystals.

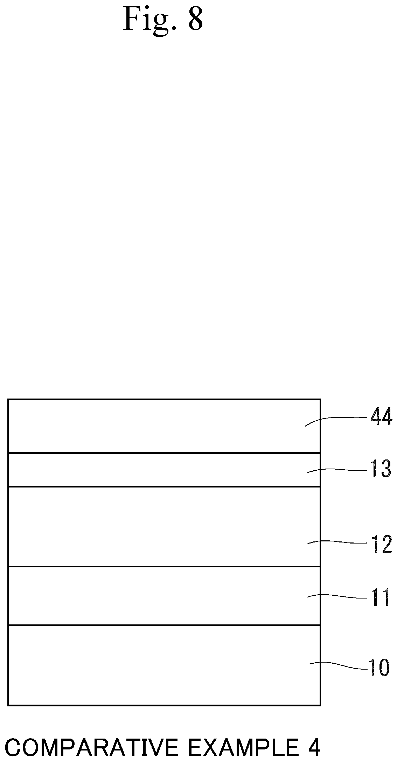

Here, how much Ga exists in the sample of Example 2 when the GaN cap layer 13 having a thickness of 0.6 nm is crystal-grown, was investigated. Specifically, a sample of Comparative Example 4 as illustrated in Fig. 8 was separately prepared. Specifically, in the sample of Comparative Example 4, similarly to the sample of Example 2, the GaN cap layer 13 having a thickness of 0.6 nm was formed on the surface of the n-AlInN layer 12 having a thickness of 43 nm, and then the hydrogen cleaning step was performed. Then, an AlInN layer 44 having a thickness of 10 nm was further crystal-grown on the surface of the GaN cap layer 13. In the sample of Example 2, the GaN layer 14 was crystal-grown on the surface of the GaN cap layer 13, but here, in order to observe how much Ga exists in the GaN cap layer 13, the AlInN layer 44 containing no Ga was crystal-grown on the upper part in the sample of Comparative Example 4.

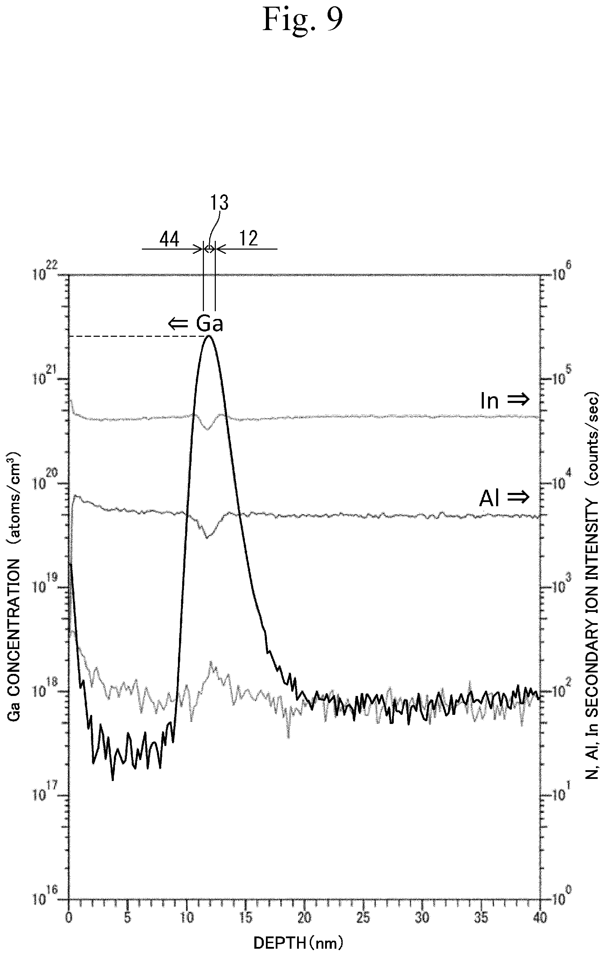

Fig. 9 show a profile of Ga, Al, and In concentrations in the depth direction in the sample of Comparative Example 4, which is obtained by SIMS analysis. As shown in Fig. 9, the peak value of the volume concentration of Ga was about $3 \times 10^{21}$ cm$^{-3}$. The full width at half maximum in the Ga volume concentration profile was about 2 nm. The surface concentration of Ga was calculated based on this profile to be $4.9 \times 10^{14}$ cm$^{-2}$. That is, it was found that when the GaN cap layer 13 having a thickness of 0.6 nm is provided as described above, Ga exists between the n-AlInN layer 12 and the AlInN layer 44 at a surface concentration of $4.9 \times 10^{14}$ cm$^{-2}$. When the thickness of the GaN cap layer 13 is changed, the surface concentration of Ga changes depending on the thickness. Specifically, it was found that the surface concentration of Ga is $2.5 \times 10^{14}$ cm$^{-2}$ when the thickness of the GaN cap layer 13 is 0.3 nm (Example 1), the surface concentration of Ga is $7.4 \times 10^{14}$ cm$^{-2}$ when the thickness of the GaN cap layer 13 is 0.9 nm (Example 3), the surface concentration of Ga is $9.8 \times 10^{14}$ cm$^{-2}$ when the thickness of the GaN cap layer 13 is 1.2 nm (Example 4), and the surface concentration of Ga is $4.1 \times 10^{15}$ cm$^{-2}$ when the thickness of the GaN cap layer 13 is 5 nm (Example 6).

As described above, it was found that when a structure including a layer containing at least Ga (GaN layer 14) and a layer containing In (GaInN quantum well active layer 15) is stacked on the surface of a layer containing at least Al and In (n-AlInN layer 12), generation of pits and dislocations can be greatly suppressed by providing the GaN cap layer 13 having a thickness of 0.3 nm or more and 5 nm or less, performing the hydrogen cleaning step, and setting the surface concentration of Ga in the GaN cap layer 13 to $2.5 \times 10^{14}$ cm$^{-2}$ or more and $4.1 \times 10^{15}$ cm$^{-2}$ or less.

The n-AlInN layer 12 is crystal-grown by performing the first layer stacking step, and then, the cap layer stacking step, the hydrogen cleaning step, and the second layer stacking step are performed. Further, the GaInN quantum well active layer 15 is crystal-grown, and then the p-AlGaN layer 16, the p-GaN layer 17, the p-GaN contact layer 18, the p-side electrode 19A, and the n-side electrode 19B are crystal-grown to prepare a light-emitting diode (nitride semiconductor light-emitting element 1).

Specifically, after the GaInN quantum well active layer 15 is crystal-grown, the following crystal growth is continuously performed. First, the p-AlGaN layer 16 having a thickness of 20 nm is crystal-grown on the surface of the GaInN quantum well active layer 15. The mole fraction of AlN in the p-AlGaN layer 16 is 20%, and the mole fraction of GaN is 80%. The supply amount of $CP_2Mg$ into the reaction furnace is adjusted such that the concentration of Mg in the p-AlGaN layer 16 becomes $2 \times 10^{19}$ cm$^{-3}$.

Next, the p-GaN layer 17 having a thickness of 70 nm is crystal-grown as a p-type clad layer on the surface of the p-AlGaN layer 16. The supply amount of CP$_2$Mg into the reaction furnace is adjusted such that the concentration of Mg in the p-GaN layer 17 becomes $2 \times 10^{19}$ cm$^{-3}$. Next, the p-GaN contact layer 18 having a thickness of 10 nm is crystal-grown on the surface of the p-GaN layer 17. The supply amount of Cp$_2$Mg into the reaction furnace is adjusted such that the Mg concentration in the p-GaN contact layer 18 becomes $2 \times 10^{20}$ cm$^{-3}$. Then, the n-side electrode 19B is provided on the back surface of the n-GaN substrate 10, an ITO electrode (p-side electrode 19A) is provided on the front surface of the p-GaN contact layer 18, and further, a pad electrode (not illustrated) made of metal is provided. In this way, the nitride semiconductor light-emitting element 1 functioning as a light-emitting diode is completed.

Next, the operation in the above examples will be described.

A method for manufacturing a nitride semiconductor light-emitting element by metal organic vapor phase epitaxy includes: a first layer stacking step of crystal-growing the n-AlInN layer 12 containing Al and In in the composition; a cap layer stacking step of crystal-growing the GaN cap layer 13 containing Ga in the composition on a surface of the n-AlInN layer 12 after performing the first layer stacking step; and a second layer stacking step of crystal-growing the GaN layer 14 containing Ga in the composition on a surface of the GaN cap layer 13 after performing the cap layer stacking step. The method for manufacturing a nitride semiconductor light-emitting element further includes a hydrogen cleaning step of stopping supply of a raw material gas into a reaction furnace and supplying hydrogen into the reaction furnace to clean surfaces of the GaN cap layer 13 and the n-AlInN layer 12, after performing the cap layer stacking step and before performing the second layer stacking step. According to this configuration, by cleaning excessive In existing on the surface of the crystal after performing the cap layer stacking step, with hydrogen, the GaN layer 14 to be stacked next can be favorably crystal-grown. Thus, in this method for manufacturing a nitride semiconductor light-emitting element, generation of pits, that is, defects such as dislocations can be sufficiently suppressed, and therefore, it is possible to produce a light-emitting diode (nitride semiconductor light-emitting element 1) with high efficiency, high output, and long life.

In the method for manufacturing a nitride semiconductor light-emitting element, the thickness of the GaN cap layer 13 in the stacking direction is 0.3 nm or more and 5 nm or less. According to this configuration, it is possible to favorably suppress dislocations occurred in the GaN layer 14 when the GaN layer 14 is stacked in the second layer stacking step.

In the method for manufacturing a nitride semiconductor light-emitting element, when the GaN cap layer 13 is provided and the hydrogen cleaning step is performed, the Ga surface concentration of the GaN cap layer 13 is $2.5 \times 10^{14}$ cm$^{-2}$ or more and $4.1 \times 10^{15}$ cm$^{-2}$ or less. According to this configuration, it is possible to favorably suppress dislocations occurred in the GaN layer 14 when the GaN layer 14 is stacked in the second layer stacking step.

In the method for manufacturing a nitride semiconductor light-emitting element, the growth temperature in the second layer stacking step is equal to or lower than the growth temperature in the first layer stacking step. According to this configuration, it is possible to suppress the influence of heat on the n-AlInN layer 12 containing In.

In the nitride semiconductor light-emitting element 1, the thickness of the GaN cap layer 13 in the stacking direction is 0.3 nm or more and 5 nm or less. According to this configuration, it is possible to favorably suppress dislocations occurred in the GaN layer 14 when the GaN layer 14 is stacked.

In the nitride semiconductor light-emitting element 1, the surface concentration of Ga in the GaN cap layer 13 is $2.5 \times 10^{14}$ cm$^{-2}$ or more and $4.1 \times 10^{15}$ cm$^{-2}$ or less. According to this configuration, it is possible to favorably suppress dislocations occurred in the GaN layer 14 when the GaN layer 14 is stacked.

<Examples 7 to 10 and Comparative Examples 5 to 7>

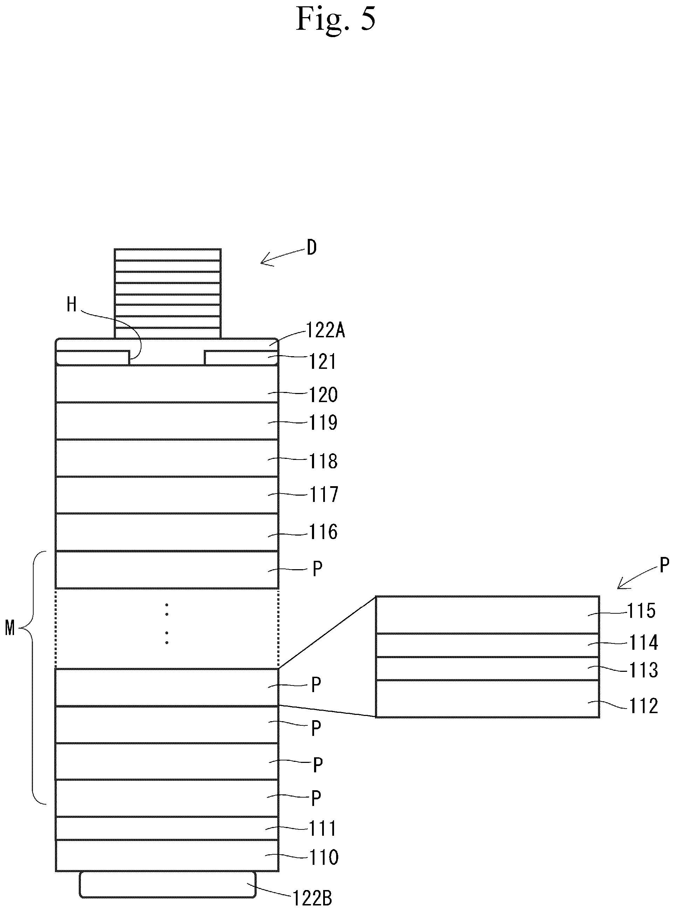

Next, another example embodying the method for manufacturing a nitride semiconductor light-emitting element of the present invention will be described with reference to the drawings. This manufacturing method is an example of formation of an n-type AlInN/GaN multilayer reflector structure including an AlGaInN composition gradient layer 114 on the surface side of an n-AlInN layer 112, and a method for manufacturing a surface emitting laser (hereinafter, also referred to as nitride semiconductor light-emitting element 2) using this structure. The n-type AlInN/GaN multilayer reflector structure can be used not only in a surface emitting laser, but also in various optical device structures such as a light-emitting diode and a solar cell. Fig. 5 illustrates a schematic cross-sectional view of an example of a structure of a surface emitting laser (nitride semiconductor light-emitting element 2) using this structure.

As illustrated in Fig. 5, the nitride semiconductor light-emitting element 2 includes an n-GaN substrate 110, an n-GaN buffer layer 111, the n-AlInN layer 112 as a first layer, a GaN cap layer 113 as a cap layer, the n-AlGaInN composition gradient layer 114 as a second layer, a first n-GaN layer 115, a second n-GaN layer 116, a GaInN quantum well active layer 117, a p-AlGaN layer 118, a p-GaN layer 119, a p-GaN contact layer 120, a p-side electrode 122A, and an n-side electrode 122B. The n-GaN substrate 110 is a GaN single crystal substrate having n-type characteristics. The nitride semiconductor light-emitting element 2 can be manufactured by performing epitaxial growth on the surface (upper surface in Fig. 5) of the n-GaN substrate 110 by using metal organic vapor phase epitaxy.

In manufacturing the nitride semiconductor light-emitting element 2, TMA, TMGa, TEGa, and TMI are used as group III materials (MO raw materials). $NH_3$ is used as a raw material gas of a group V material. $SiH_4$ is used as a raw material gas of a donor impurity. $CP_2Mg$ is used as a MO raw material of an acceptor impurity.

First, the n-GaN buffer layer 111 as a buffer layer is crystal-grown with a thickness of 500 nm on the surface of the n-GaN substrate 110. Specifically, the n-GaN substrate 110 is disposed in a reaction furnace of an MOVPE apparatus. Then, the temperature in the reaction furnace is adjusted such that the temperature (growth temperature) of the n-GaN substrate 110 is 1,050°C, and $H_2$ is supplied as a carrier gas into the reaction furnace. The supply amount of $SiH_4$ into the reaction furnace is adjusted such that the concentration of Si in the n-GaN buffer layer 111 becomes $5 \times 10^{18}$ cm$^{-3}$.

[First layer stacking step]

Next, a first layer stacking step is performed. Specifically, the n-AlInN layer 112 is epitaxially grown on the surface of the n-GaN buffer layer 111. Specifically, the temperature in the reaction furnace is adjusted such that the temperature (growth temperature) of the n-GaN substrate 110 becomes 840°C, and $N_2$ is supplied as a carrier gas into the reaction furnace. In addition, TMA, TMI, $SiH_4$, and $NH_3$ are supplied into the reaction furnace to crystal-grow the n-AlInN layer 112 having a thickness of 38 nm. The mole fraction of AlN in the n-AlInN layer 112 is 82%, and the mole fraction of InN is 18%. The supply amount of $SiH_4$ into the reaction furnace is adjusted such that the concentration of Si in the n-AlInN layer 112 becomes $1.5 \times 10^{19}$ cm$^{-3}$. In addition to $N_2$, the carrier gas may be an inert gas such as Ar or Ne (neon), or a mixed gas thereof.

[Cap layer stacking step]

Next, a cap layer stacking step is performed. Specifically, the supply of TMA, TMI, and $SiH_4$ is stopped and TEGa is supplied into the reaction furnace while the temperature (growth temperature) of the n-GaN substrate 110 and the supply of the carrier gas ($N_2$) and $NH_3$ into the reaction furnace are maintained, whereby the GaN cap layer 113 is crystal-grown on the surface of the n-AlInN layer 112. The thickness of the GaN cap layer 113 is 0.3 nm.

[Hydrogen cleaning step]

After the supply of TEGa into the reaction furnace is stopped to complete the crystal growth of the GaN cap layer 113, a hydrogen cleaning step is performed. Specifically, the temperature (growth temperature) of the n-GaN substrate 110 is maintained at the temperature in the cap layer stacking step (840°C), and the carrier gas supplied into the reaction furnace is gradually switched from $N_2$ to $H_2$. The supply of $NH_3$ into the reaction furnace is maintained. Specifically, the ratio of $N_2$ is decreased and the ratio of $H_2$ is increased while the flow rate of the carrier gas supplied into the reaction furnace is maintained at a predetermined flow rate, and the carrier gas is switched from $N_2$ to $H_2$ over 30 seconds. $H_2$ starts to be supplied into the reaction furnace by this operation, and the surface of the n-AlInN layer 112 including the thin GaN cap layer 113 can be cleaned with $H_2$. Then, a state in which only $H_2$ is supplied as a carrier gas into the reaction furnace is maintained as it is for a predetermined time. Thereafter, the carrier gas is gradually switched from $H_2$ to $N_2$. Specifically, the ratio of $H_2$ is decreased and the ratio of $N_2$ is increased while the flow rate of the carrier gas supplied into the reaction furnace is maintained at a predetermined flow rate, and the carrier gas is switched from $H_2$ to $N_2$ over 30 seconds.

[Second layer stacking step]

After the cap layer stacking step and the hydrogen cleaning step are performed, the second layer stacking step is performed. Specifically, the n-AlGaInN composition gradient layer 114 containing Al and In in the composition and having a thickness of 5 nm is crystal-grown in a state in which the carrier gas is $N_2$ while the growth temperature is maintained at a temperature (840°C) used at the time of crystal-growing the n-AlInN layer 112. The n-AlGaInN composition gradient layer 114 is crystal-grown in the following manner. The growth temperature in the second layer stacking step is the same as the growth temperature in the first layer stacking step.

First, the crystal growth is started with the supply amounts of TMA and TMI into the reaction furnace set to the supply amounts used at the time of growing the n-AlInN layer 112, and then the supply amounts of TMA and TMI into the reaction furnace are gradually decreased. At the same time, the supply of TEGa, which has not been supplied immediately after the start of the second layer stacking step, is supplied into the reaction furnace is started, and the supply amount of TEGa is gradually increased. Finally, the supply of TMA and TMI into the reaction furnace is stopped, and the supply amount of TEGa is gradually increased to the same extent as the growth rate of the n-AlInN layer 112. As a result, the composition is continuously changed in the stacking direction from the n-AlInN layer 112 to the first n-GaN layer 115, and the n-AlGaInN composition gradient layer 114 having a thickness of 5 nm is crystal-grown. In addition, in order to obtain n-type characteristics, the supply amount of $SiH_4$ into the reaction furnace is adjusted such that the concentration of Si in the n-AlGaInN composition gradient layer 114 is $6 \times 10^{19}$ cm$^{-3}$.

After the supply of TMA, TMI, TEGa, and $SiH_4$ is stopped to complete the crystal growth of the n-AlGaInN composition gradient layer 114 having a thickness of 5 nm, the temperature (growth temperature) of the n-GaN substrate 110 is increased to 1,050°C, which is the growth temperature of the first n-GaN layer 115, while the supply of $NH_3$ into the reaction furnace is maintained. At this time, since the supply of TMA, TMI, TEGa, and $SiH_4$ into the reaction furnace has been stopped, the crystal growth is interrupted. Then, the carrier gas is gradually switched from $N_2$ to $H_2$ when the crystal growth is interrupted.

Then, after the temperature of the n-GaN substrate 110 reaches 1,050°C, the supply of TMGa into the reaction furnace is started, and the first n-GaN layer 115 having a thickness of 43 nm is crystal-grown. The supply amount of $SiH_4$ into the reaction furnace is adjusted such that the concentration of Si in the first n-GaN layer 115 becomes $5 \times 10^{18}$ cm$^{-3}$. The n-AlInN layer 112, the GaN cap layer 113, the n-AlGaInN composition gradient layer 114, and the first n-GaN layer 115 correspond to one pair P of the multilayer reflector structure.

After the crystal growth of the first n-GaN layer 115, the supply of TMGa into the reaction furnace is stopped to interrupt the crystal growth in order to grow the n-AlInN layer 112 on the surface of the first n-GaN layer 115 again (that is, to repeatedly crystal-grow the pair P). Then, the temperature of the n-GaN substrate 110 is lowered from 1,050°C to 840°C when the crystal growth is interrupted. At this time, the carrier gas is gradually switched from $H_2$ to $N_2$. In this way, the crystal growth of one pair P (n-AlInN layer 112, GaN cap layer 113, n-AlGaInN composition gradient layer 114, and first n-GaN layer 115) of the multilayer reflector structure is repeated 40 times, whereby an n-AlInN/GaN multilayer reflector M in which 40 pairs P are stacked is crystal-grown.

[Verification of ratios of $H_2$ and $NH_3$ supplied into reaction furnace in hydrogen cleaning step]

Here, it is considered that the effect of the hydrogen cleaning step (that is, suppression of pit density on the surface of the stacked crystals) is proportional to the flow rate of $H_2$ supplied into the reaction furnace in the hydrogen cleaning step (hereinafter, also simply referred to as flow rate of $H_2$) and the supply time for supplying $H_2$ into the reaction furnace in the hydrogen cleaning step. On the other hand, $NH_3$ is supplied into the reaction furnace for protecting the surface of the crystal in the hydrogen cleaning step. If the effect of protecting the surface of the crystal is too strong (that is, the flow rate of $NH_3$ into the reaction furnace in the hydrogen cleaning step (hereinafter, simply referred to as flow rate of $NH_3$) is too large), the effect of removing In is weakened. Accordingly, it is considered that the effect of the hydrogen cleaning step is inversely proportional to the flow rate of $NH_3$. Therefore, when the effect of this hydrogen cleaning step is defined as a numerical value A (hereinafter, also simply referred to as numerical value A) and this numerical value A is quantified by the flow rate F1

[slm] of $H_2$, the supply time T [min] of $H_2$ into the reaction furnace, and the flow rate F2 [slm] of $NH_3$, the numerical value A can be expressed by the following equation.

[Mathematical Formula 1]

$$A = ( F1 \times T ) / F2$$

When this numerical value A is too small, unnecessary In existing on the surface of the n-AlInN layer 112 cannot be sufficiently removed. When this numerical value A is too large, the flatness of the surface of the n-AlInN layer 112 may be deteriorated and new dislocations may occur. Therefore, it is considered that the numerical value A brings about an appropriate effect (suppression of pit density on the surface of the stacked crystals) within a predetermined numerical range.

In order to grasp the relationship between the numerical value A and this effect, six kinds of samples of Examples 7 to 10 and Comparative Examples 5 and 6 were prepared in which the n-GaN buffer layer 111 was crystal-grown on the surface of the n-GaN substrate 110, and then the pair P was repeatedly crystal-grown ten times. Specifically, in these samples, the flow rate F1 of $H_2$ is constant (31 [slm]), and the supply time T of $H_2$ into the reaction furnace and the flow rate F2 of $NH_3$ are changed.

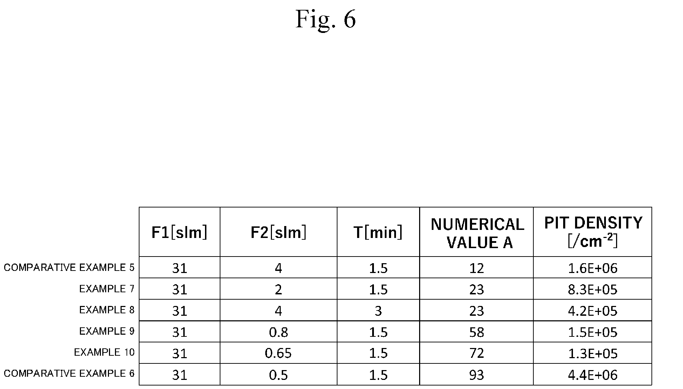

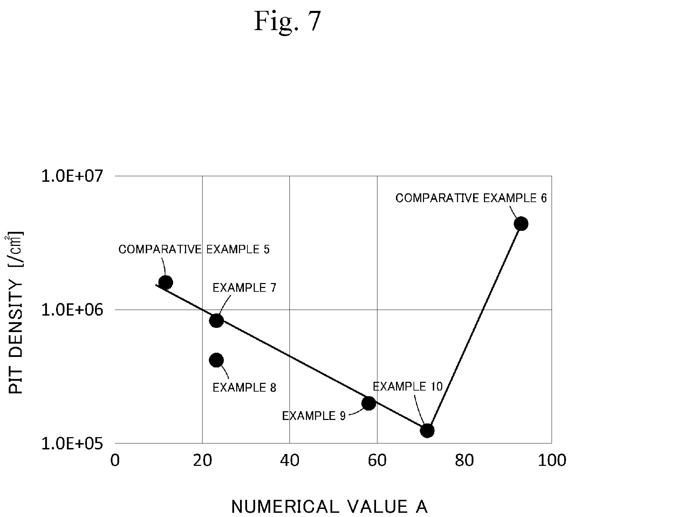

As shown in Fig. 6, in the sample of Comparative Example 5, the numerical value A was 12, and the pit density of the surface on which ten pairs P were stacked (hereinafter, also simply referred to as pit density) was $1.6 \times 10^6$ cm$^{-2}$. The sample of Example 7 had a numerical value A of 23 and a pit density of $8.3 \times 10^5$ cm$^{-2}$. The sample of Example 8 had a numerical value A of 23 and a pit density of $4.2 \times 10^5$ cm$^{-2}$. The sample of Example 9 had a numerical value A of 58 and a pit density of $1.5 \times 10^5$ cm$^{-2}$. The sample of Example 10 had a numerical value A of 72 and a pit density of $1.3 \times 10^5$ cm$^{-2}$. It was found that until the numerical value A reaches 72, the effect becomes more remarkable as the hydrogen cleaning step is performed. On the other hand, in the sample of Comparative Example 6, the numerical value A was 93, and the pit density tended to increase to $4.4 \times 10^6$ cm$^{-2}$. That is, as shown in Fig. 7, it was found that when the numerical value A exceeds about 80, a disadvantage that the pit density increases is caused more than the merit obtained by the hydrogen cleaning step.

As shown in Fig. 7, it was found that when the numerical value A exceeds 20, the pit density is equal to or less than the guaranteed value ($1 \times 10^6$ cm$^{-3}$) of the dislocation density of the n-GaN substrate 110. On the other hand, it was also found that when the numerical value A exceeds 80, the pit density approaches $1 \times 10^6$ cm$^{-3}$ and exceeds this value. That is, it was found that there is an appropriate range (20 to 80) of the numerical value A in order to favorably reduce the pit density on the surface of the n-AlInN/GaN multilayer reflector M in which a plurality of pairs P are stacked. Note that, in this verification, a sample obtained by repeating the crystal growth of the pair P ten times is used, but it is considered that the effect of suppressing the pit density on the surface of the stacked crystals can be exhibited by setting the numerical value A to this range (20 to 80) even when the number of stacked pairs P is 11 or more. In other words, when the numerical value A determined from the flow rate F1 [slm] of $H_2$, the supply time T [min] of $H_2$ into the reaction furnace, and the flow rate F2 [slm] of $NH_3$ is set to a value between 20 or more and 80 or less, the pit density on the surface of the n-AlInN/GaN multilayer reflector M in which a plurality of pairs P are stacked can be favorably reduced.

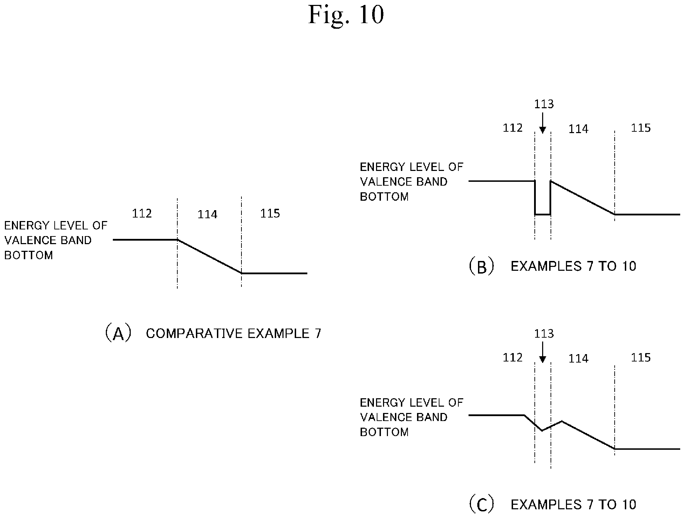

Incidentally, the reason why the n-AlGaInN composition gradient layer 114 is provided between the n-AlInN layer 112 and the first n-GaN layer 115 is to substantially eliminate the band offset of the bottom of the valence band formed between the n-AlInN layer 112 and the first n-GaN layer 115 to thereby eliminate the potential barrier formed at the hetero interface so that electron transfer is smoothly performed (that is, reduce the resistance) as shown in Fig. 10(A). On the other hand, in Examples 7 to 10, the GaN cap layer 113 is provided between the n-AlInN layer 112 and the n-AlGaInN composition gradient layer 114, and thus, theoretically, a large offset occurs in the energy level of the bottom of the valence band as shown in Fig. 10(B). When the GaN cap layer 113 is sufficiently thin, this influence is not large, but when the number of pairs P is increased, there has been a concern that the influence is accumulated and the resistance is increased.

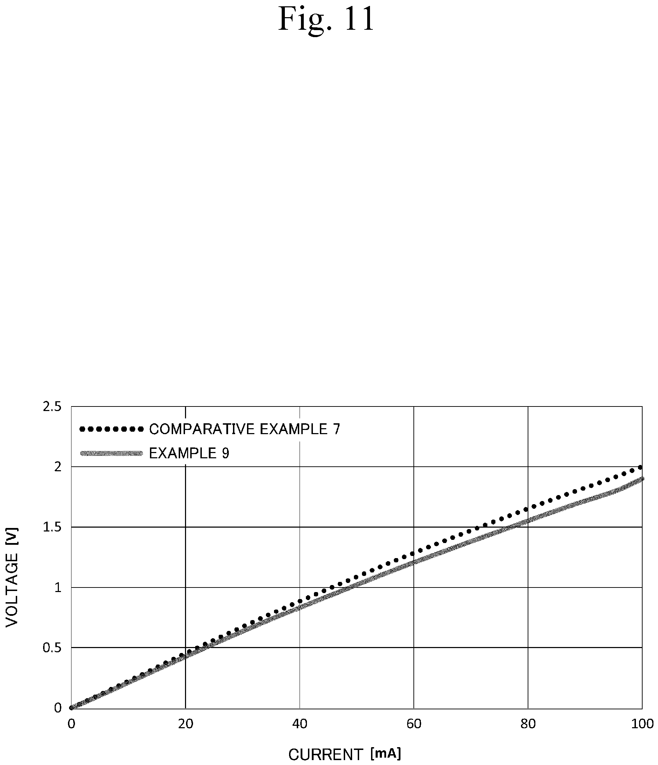

Thus, as Comparative Example 7, an n-AlInN/-GaN multilayer reflector was formed by repeating the crystal growth of the n-AlInN layer 112, the n-AlGaInN composition gradient layer 114, and the first n-GaN layer 115 ten times without providing the GaN cap layer 113 and without performing a hydrogen cleaning step, and the current-voltage characteristics thereof were measured. For comparison, the current-voltage characteristics of the sample of Example 9 were also measured. These results are shown in Fig. 11. As shown in Fig. 11, it was found that even when the GaN cap layer 113 is provided, the current-voltage characteristics are not significantly deteriorated as compared with the current-voltage characteristics in Example 9. This is because the actual GaN cap layer 113 does not have a structure having a steep interface as shown in Fig. 10(B), but has a structure in which Ga is diffused to some extent into layers vertically adjacent to each other (that is, the n-AlInN layer 112 and the n-AlGaInN composition gradient layer 114) as can be seen from the SIMS result of Fig. 9, and thus has a structure in which the band offset in the GaN cap layer 113 is reduced and the energy level is gently changed (Fig. 10(C)). Meanwhile, as shown in the Ga profile in Fig. 9, Ga is still concentrated in a region between the n-AlInN layer 112 and the n-AlGaInN composition gradient layer 114, and the concentration of Ga is higher in this region than in a surrounding region (n-AlInN layer 112 and n-AlGaInN composition gradient layer 114). That is, in the nitride semiconductor light-emitting element 2, the band gap in the GaN cap layer 113 is smaller than the band gap in a region adjacent to the GaN cap layer 113, that is, a region having a low Ga concentration in the n-AlInN layer 112 and the n-AlGaInN composition gradient layer 114. As described above, it has been clear that the present invention can satisfy both of the structural characteristics of surface flatness and the electrical characteristics.

After the crystal growth of the pair P is repeated 40 times to form an n-AlInN/GaN multilayer reflector M, the second n-GaN layer 116 having a thickness of 400 nm is crystal-grown at a growth temperature of 1,050°C on the surface of the n-AlInN/GaN multilayer reflector M. The supply amount of $SiH_4$ into the reaction furnace is adjusted such that the concentration of Si in the second n-GaN layer 116 becomes $5 \times 10^{18}$ cm$^{-3}$.

Next, the GaInN quantum well active layer 117 having a configuration in which one pair of a GaInN quantum well layer and a GaN barrier layer is stacked five times is grown on the surface of the second n-GaN layer 116. Then, the p-AlGaN layer 118 having a thickness of 20 nm is crystal-grown on the surface of the GaInN quantum well active layer 117. The mole fraction of AlN in the p-AlGaN layer 118 is 20%, and the mole fraction of GaN is 80%. The supply amount of $Cp_2Mg$ is adjusted such that the concentration of Mg in the p-AlGaN layer 118 becomes $2 \times 10^{19}$ cm$^{-3}$.

Next, the p-GaN layer 119 having a thickness of 70 nm is crystal-grown as a p-type clad layer on the surface of the p-AlGaN layer 118. The supply amount of $Cp_2Mg$ is adjusted such that the concentration of Mg in the p-GaN layer 119 becomes $2 \times 10^{19}$ cm$^{-3}$. Then, the p-GaN contact layer 120 is crystal-grown on the surface of the p-GaN layer 119. The supply amount of $Cp_2Mg$ is adjusted such that the concentration of Mg in the p-GaN contact layer 120 becomes $2 \times 10^{20}$ cm$^{-3}$.

In this way, a resonator structure including the n-AlInN/GaN multilayer reflector M in which the crystal growth of the pair P having a high-quality layer containing at least Ga and In (n-AlGaInN composition gradient layer 114) is repeated 40 times, and the GaInN quantum well active layer 117 that is sandwiched by the pn junction and emits light in the violet region is formed on the surface of the layer containing at least Al and In (n-AlInN layer 112). This resonator has a length corresponding to an integral multiple of an emission wavelength, and the resonator length corresponds to four wavelengths.

As illustrated in Fig. 5, the surface emitting laser is completed by crystal-growing an insulating film 121, the p-side electrode 122A, the n-side electrode 122B, and a $SiO_2/Nb_2O_5$ dielectric multilayer reflector D, on a wafer having the n-AlInN/GaN multilayer reflector M and the resonator structure. Hereinafter, a process of producing the surface emitting laser (nitride semiconductor light-emitting element 2) by crystal-growing the insulating film 121, the p-side electrode 122A, the n-side electrode 122B, and the $SiO_2/Nb_2O_5$ dielectric multilayer reflector D will be described.

First, after the p-GaN contact layer 120 is crystal-grown, $H_2$ is desorbed from the p-type semiconductor layers (p-AlGaN layer 118, p-GaN layer 119, p-GaN contact layer 120) of the semiconductor wafer, and Mg which is a p-type dopant added to the p-type semiconductor layers is activated. Next, patterning with a photoresist is formed on the surface of the semiconductor wafer, and then etching is partially performed, thereby forming a mesa structure having a circular shape with a diameter of 40 $\mu$m as an element.

Thereafter, a $SiO_2$ film having a thickness of 20 nm is stacked on the surface of the p-GaN contact layer 120, and the insulating film 121 having a circular opening H with a diameter of 10 $\mu$m is formed by photolithography and sputtering. Then, the transparent p-side electrode 122A made of ITO is formed using a sputtering method so as to be in contact with the surface of the p-GaN contact layer 120 exposed from the opening H. Along with this formation, the n-side electrode 122B is provided on the back surface of the n-GaN substrate 110. Then, a pad electrode made of Cr/Ni/Au is formed on the outer peripheral portion of the surface of the p-side electrode 122A (not illustrated).

Finally, the $SiO_2/Nb_2O_5$ dielectric multilayer reflector D is crystal-grown on the surface of the p-side electrode 122A by photolithography and sputtering. In this way, the nitride semiconductor light-emitting element 2 is completed that includes the $SiO_2/Nb_2O_5$ dielectric multilayer reflector D on the upper side of the GaInN quantum well active layer 117 and the n-AlInN/GaN multilayer reflector M on the lower side of the GaInN quantum well active layer 117, and that functions as a vertical cavity surface emitting laser having a resonator length corresponding to an integral multiple of a wavelength.

In the method for manufacturing a nitride semiconductor light-emitting element, the numerical value A in Equation 1, determined from the flow rate F1 [slm] of hydrogen supplied into the reaction furnace in the hydrogen cleaning step, the supply time T [min] for supplying hydrogen into the reaction furnace in the hydrogen cleaning step, and the flow rate F2 [slm] of ammonia supplied into the reaction furnace in the hydrogen cleaning step is 20 or more and 80 or less.

$$A = (F1 \times T)/F2 \cdots Equation\ 1$$

According to this configuration, the effect of cleaning with hydrogen on the surface of the crystal after the cap layer stacking step can be enhanced by adjusting the flow rate F1 [slm] of hydrogen supplied into the reaction furnace in the hydrogen cleaning step, the supply time T [min] for supplying hydrogen into the reaction furnace in the hydrogen cleaning step, and the flow rate F2 [slm] of ammonia supplied into the reaction furnace in the hydrogen cleaning step such that the numerical value A is set within the above-described range.

The nitride semiconductor light-emitting element 2 includes the n-AlInN layer 112 containing Al and In in the composition, the GaN cap layer 113 stacked on the surface of the n-AlInN layer 112 and containing Ga in the composition, and the n-AlGaInN composition gradient layer 114 stacked on the surface of the GaN cap layer 113 and containing Ga and In in the composition. The band gap in the GaN cap layer 113 is smaller than the band gap in a region adjacent to the GaN cap layer 113 in the n-AlInN layer 112 and the n-AlGaInN composition gradient layer 114.

According to this configuration, the n-AlGaInN composition gradient layer 114 to be stacked next can be favorably crystal-grown due to the GaN cap layer 113, and further, Ga contained in the GaN cap layer 113 is diffused to some extent into the n-AlInN layer 112 and the n-AlGaInN composition gradient layer 114 vertically adjacent to each other, and the band offset in the GaN cap layer 113 is reduced, so that electrons can be smoothly moved in the GaN cap layer 113.

It should be considered that the embodiments disclosed herein are an example in all respects and are not restrictive. The scope of the present invention is not limited to the embodiments disclosed herein, but is indicated by the claims, and is intended to include all modifications within the meaning and scope equivalent to the claims.

(1) Unlike the above examples, Ge, Te, or the like may be used as the n-type impurity. In addition, Mg, Zn, Be, Ca, Sr, Ba, or the like may be used as the p-type impurity.

(2) Unlike the above examples, crystal growth may be performed using another substrate such as a sapphire substrate.

(3) Unlike the above examples, in the second layer stacking step, a layer containing only In in the composition may be crystal-grown.

(4) Unlike the above examples, the GaN cap layer may contain an element other than GaN.

(5) Unlike the above examples, the flow rate and the supply time of $H_2$ may be changed in order to adjust the numerical value A.

REFERENCE SIGNS LIST

1, 2 Nitride semiconductor light-emitting element
12, 112 n-AlInN layer (first layer)
13, 113 GaN cap layer (cap layer)
14 GaN layer (second layer)
114 n-AlGaInN composition gradient layer (second layer)
A Numerical value
F1 Flow rate of hydrogen supplied into reaction furnace in hydrogen cleaning step

F2 Flow rate of ammonia supplied into reaction furnace in hydrogen cleaning step

T Supply time for supplying hydrogen into reaction furnace in hydrogen cleaning step

**Claims**

1. A method for manufacturing a nitride semiconductor light-emitting element by metal organic vapor phase epitaxy, the method comprising:

   a first layer stacking step of crystal-growing a first layer containing Al and In in a composition;
   a cap layer stacking step of crystal-growing a cap layer containing Ga in a composition on a surface of the first layer after performing the first layer stacking step; and
   a second layer stacking step of crystal-growing a second layer containing at least one of Ga and In in a composition on a surface of the cap layer after performing the cap layer stacking step, wherein
   the method further includes a hydrogen cleaning step of stopping supply of a raw material gas into a reaction furnace and supplying hydrogen into the reaction furnace to clean at least a surface of the cap layer, after performing the cap layer stacking step and before performing the second layer stacking step.

2. The method for manufacturing a nitride semiconductor light-emitting element according to claim 1, wherein a thickness of the cap layer in a stacking direction is 0.3 nm or more and 5 nm or less.

3. The method for manufacturing a nitride semiconductor light-emitting element according to claim 1 or 2, wherein a numerical value A in Equation 1, determined from a flow rate F1 [slm] of hydrogen supplied into the reaction furnace in the hydrogen cleaning step, a supply time T [min] for supplying hydrogen into the reaction furnace in the hydrogen cleaning step, and a flow rate F2 [slm] of ammonia supplied into the reaction furnace in the hydrogen cleaning step is 20 or more and 80 or less.

   $$A = (F1 \times T)/F2 \cdots \text{Equation 1}$$

4. The method for manufacturing a nitride semiconductor light-emitting element according to any one of claims 1 to 3, wherein a growth temperature in the second layer stacking step is equal to or lower than a growth temperature in the first layer stacking step.

5. A nitride semiconductor light-emitting element comprising:

   a first layer containing Al and In in a composition;
   a cap layer stacked on a surface of the first layer and containing Ga in a composition; and
   a second layer stacked on a surface of the cap layer and containing at least one of Ga and In in a composition, wherein
   a band gap of the cap layer is smaller than a band gap of a region adjacent to the cap layer in the first layer and the second layer.

6. The nitride semiconductor light-emitting element according to claim 5, wherein a thickness of the cap layer in a stacking direction is 0.3 nm or more and 5 nm or less.

7. The nitride semiconductor light-emitting element according to claim 5 or 6, wherein a surface concentration of Ga in the cap layer is $2.5 \times 10^{14}$ cm$^{-2}$ or more and $4.1 \times 10^{15}$ cm$^{-2}$ or less.

# Fig. 1

19A — 18 — 17 — 16 — 15 — 14 — 13 — 12 — 11 — 10 — 19B

# Fig. 2

TMI
TMA
TEGa
$NH_3$
$SH_4$

$H_2$

$N_2$

$N_2$

840°C
797°C

FIRST LAYER
STACKING STEP

1.5min   1.5min

HYDROGEN
CLEANING STEP

SECOND LAYER
STACKING STEP

CAP LAYER
STACKING STEP

# Fig. 3

(A) COMPARATIVE EXAMPLE 1

0nm

$8.8 \times 10^8$[cm⁻²]

(B) COMPARATIVE EXAMPLE 2

0.15nm

$2.6 \times 10^7$[cm⁻²]

(C) EXAMPLE 1

0.3nm

$6.3 \times 10^6$[cm⁻²]

(D) EXAMPLE 2

0.6nm

$7.5 \times 10^5$[cm⁻²]

(I) COMPARATIVE EXAMPLE 3

NO HYDROGEN TREATMENT

$1.5 \times 10^7$[cm⁻²]

(E) EXAMPLE 3

0.9nm

$2.3 \times 10^6$[cm⁻²]

(F) EXAMPLE 4

1.2nm

$5.0 \times 10^6$[cm⁻²]

(G) EXAMPLE 5

2.4nm

$4.5 \times 10^6$[cm⁻²]

(H) EXAMPLE 6

5nm

$6.2 \times 10^6$[cm⁻²]

Fig. 4

# Fig. 5

Fig. 6

| | F1[slm] | F2[slm] | T[min] | NUMERICAL VALUE A | PIT DENSITY [/cm$^{-2}$] |
|---|---|---|---|---|---|
| COMPARATIVE EXAMPLE 5 | 31 | 4 | 1.5 | 12 | 1.6E+06 |
| EXAMPLE 7 | 31 | 2 | 1.5 | 23 | 8.3E+05 |
| EXAMPLE 8 | 31 | 4 | 3 | 23 | 4.2E+05 |
| EXAMPLE 9 | 31 | 0.8 | 1.5 | 58 | 1.5E+05 |
| EXAMPLE 10 | 31 | 0.65 | 1.5 | 72 | 1.3E+05 |
| COMPARATIVE EXAMPLE 6 | 31 | 0.5 | 1.5 | 93 | 4.4E+06 |

Fig. 7

# Fig. 8

COMPARATIVE EXAMPLE 4

# Fig. 9

# Fig. 10

112    114    115

ENERGY LEVEL OF
VALENCE BAND
BOTTOM

(A)    COMPARATIVE EXAMPLE 7

113

112    114    115

ENERGY LEVEL OF
VALENCE BAND
BOTTOM

(B)    EXAMPLES 7 TO 10

113

112    114    115

ENERGY LEVEL OF
VALENCE BAND
BOTTOM

(C)    EXAMPLES 7 TO 10

# Fig. 11

EP 4 496 157 A1

# INTERNATIONAL SEARCH REPORT

International application No.

**PCT/JP2023/009011**

**A. CLASSIFICATION OF SUBJECT MATTER**

***H01S 5/343***(2006.01)i; ***C23C 16/18***(2006.01)i; ***C23C 16/34***(2006.01)i; ***C30B 25/02***(2006.01)i; ***C30B 29/38***(2006.01)i; ***H01L 21/205***(2006.01)i; ***H01L 33/10***(2010.01)i; ***H01L 33/32***(2010.01)i; ***H01S 5/183***(2006.01)i
FI: H01S5/343 610; C23C16/18; C23C16/34; C30B25/02; C30B29/38 D; H01L21/205; H01L33/32; H01L33/10; H01S5/183

According to International Patent Classification (IPC) or to both national classification and IPC

**B. FIELDS SEARCHED**

Minimum documentation searched (classification system followed by classification symbols)

H01L21/205, 21/31, 21/365, 21/469, 21/86, 33/00-33/46, H01S5/00-5/50, C23C16/00-16/56, C30B1/00-35/00

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X | JP 2018-98347 A (UNIV MEIJO) 21 June 2018 (2018-06-21) paragraphs [0016]-[0033], fig. 1-3 | 1 |
| A | | 2-4, 6-7 |
| X | JP 7-297476 A (HITACHI LTD) 10 November 1995 (1995-11-10) paragraph [0013], fig. 1 | 5 |
| A | CN 101859982 A (SHANDONG CANYUAN OPTO-ELECTRONIC TECHNOLOGY CO., LTD.) 13 October 2010 (2010-10-13) entire text, all drawings | 1-7 |

☐ Further documents are listed in the continuation of Box C.　　☑ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed

"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **16 May 2023** | **30 May 2023** |

| Name and mailing address of the ISA/JP | Authorized officer |
|---|---|
| **Japan Patent Office (ISA/JP)** **3-4-3 Kasumigaseki, Chiyoda-ku, Tokyo 100-8915 Japan** | |
| | Telephone No. |

Form PCT/ISA/210 (second sheet) (January 2015)

**INTERNATIONAL SEARCH REPORT**
Information on patent family members

International application No.

**PCT/JP2023/009011**

| Patent document cited in search report | | | Publication date (day/month/year) | Patent family member(s) | Publication date (day/month/year) |
|---|---|---|---|---|---|
| JP | 2018-98347 | A | 21 June 2018 | US 2018/0166855 A1 paragraphs [0026]-[0043], fig. 1-3 EP 3336981 A1 | |
| JP | 7-297476 | A | 10 November 1995 | (Family: none) | |
| CN | 101859982 | A | 13 October 2010 | (Family: none) | |

Form PCT/ISA/210 (patent family annex) (January 2015)

**EP 4 496 157 A1**

**Patent documents cited in the description**

- JP 2018014444 A
- JP 2018098347 A